# EUROPEAN PATENT APPLICATION

(11) **EP 3 640 987 A1**
(43) Date of publication of application: **22.04.2020**
(21) Application number: 18817123.5
(22) Date of filing: 07.05.2018
(51) Int. Cl.: H01L 27/146, G02B 5/20, H04N 5/369

(54) **IMAGING ELEMENT, IMAGING DEVICE AND IMAGING METHOD**

(30) Priority: 15.06.2017 JP 2017118052
(71) Applicant: Nikon Corporation, Tokyo 108-6290 (JP)
(72) Inventor: NISHIYAMA, Madoka, Tokyo 108-6290 (JP); WATANABE, Yoshiyuki, Tokyo 108-6290 (JP); OHKOUCHI, Naoki, Tokyo 108-6290 (JP); TSUKAMOTO, Hiroyuki, Tokyo 108-6290 (JP)
(74) Representative: Hoffmann Eitle
(86) International application number: PCT/JP2018/017678
(87) International publication number: WO 2018/230186

(57) **Abstract**

Provided is an imaging device including a light receiving portion including a plurality of photoelectric conversion elements arranged in a two-dimensional manner, and a spectral filter including a storage portion that stores a substance composed of a fluid or a gas, an inflow portion through which the substance flows into the storage portion, and an outflow portion through which the substance flows out from the storage portion, the spectral filter having a spectral characteristic corresponding to a refractive index of the substance, the spectral filter being each provided for one or more of the photoelectric conversion elements. In addition, provided is an optical element that includes an optical filter including a storage portion that stores a substance composed of a fluid or a gas, an inflow portion through which the substance flows into the storage portion, and an outflow portion through which the substance flows out from the storage portion, the optical filter having an optical characteristic corresponding to a refractive index of the substance.

## Description

### BACKGROUND

### 1. TECHNICAL FIELD

The present invention relates to an imaging device, an imaging apparatus, and an imaging method.

### 2. RELATED ART

Up to now, an optical fiber has been proposed in which a transmittance characteristic is changed by changing a refractive index of a filling fluid (for example, see PTL 1) . PTL 1 Japanese Unexamined Patent Application Publication No 2014-215518

However, only one type of the transmittance characteristic is obtained when filling with a substance is performed once.

According to a first aspect of the present invention, there is provided an imaging device including a light receiving portion including a plurality of photoelectric conversion elements arranged in a two-dimensional manner, and a spectral filter including a storage portion that stores a substance composed of a fluid or a gas, an inflow portion through which the substance flows into the storage portion, and an outflow portion through which the substance flows out from the storage portion, the spectral filter having a spectral characteristic corresponding to a refractive index of the substance, the spectral filter being each provided for one or more of the photoelectric conversion elements.

According to a second aspect of the present invention, there is provided an imaging apparatus including the imaging device according to the first aspect of the present invention, and a retention portion that is connected to the inflow portion and the outflow portion and retains the substance flowing out from the storage portion, the retention portion causing the retained substance to flow into the inflow portion and causing the substance to be stored in the storage portion again.

According to a third aspect of the present invention, there is provided an optical element that includes an optical filter including a storage portion that stores a substance composed of a fluid or a gas, an inflow portion through which the substance flows into the storage portion, and an outflow portion through which the substance flows out from the storage portion, the optical filter having an optical characteristic corresponding to a refractive index of the substance.

According to the fourth aspect of the present invention, there is provided an imaging method including causing a substance composed of a fluid or a gas to flow from an inflow portion into a storage portion of a spectral filter, the spectral filter being provided to correspond to one or more of a plurality of photoelectric conversion elements arranged in a two-dimensional manner, causing the plurality of photoelectric conversion elements to receive light that has transmitted through a wavelength band corresponding to a refractive index of the substance among lights incident on the spectral filter, and causing the substance to flow from the storage portion to an outflow portion.

The summary clause does not necessarily describe all necessary features of the embodiments of the present invention. The present invention may also be a sub-combination of the features described above.

### BRIEF DESCRIPTION OF THE DRAWINGS

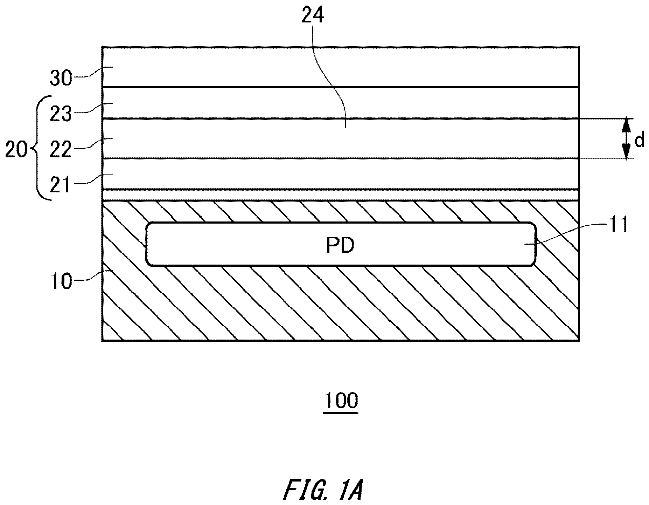

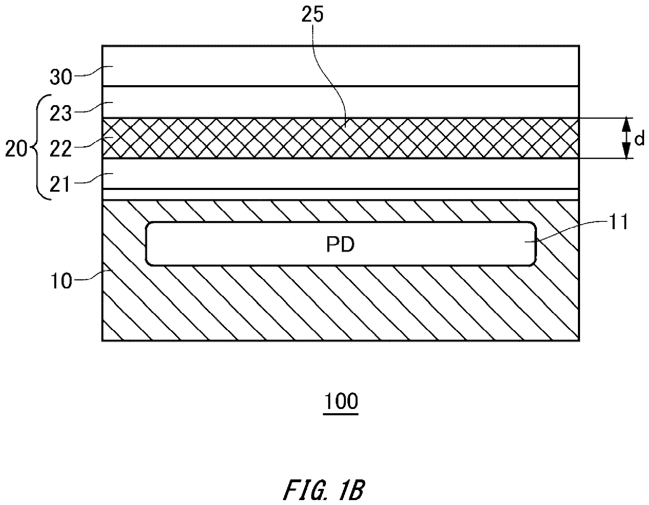

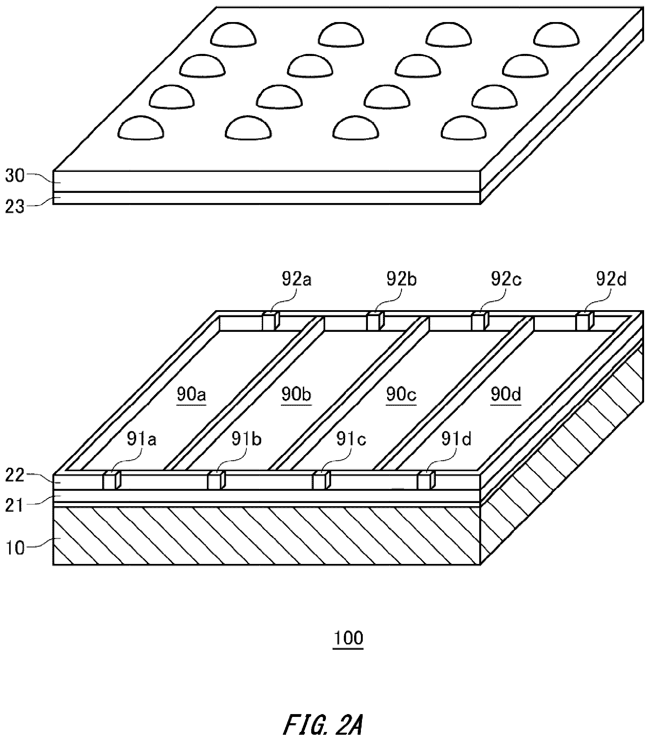

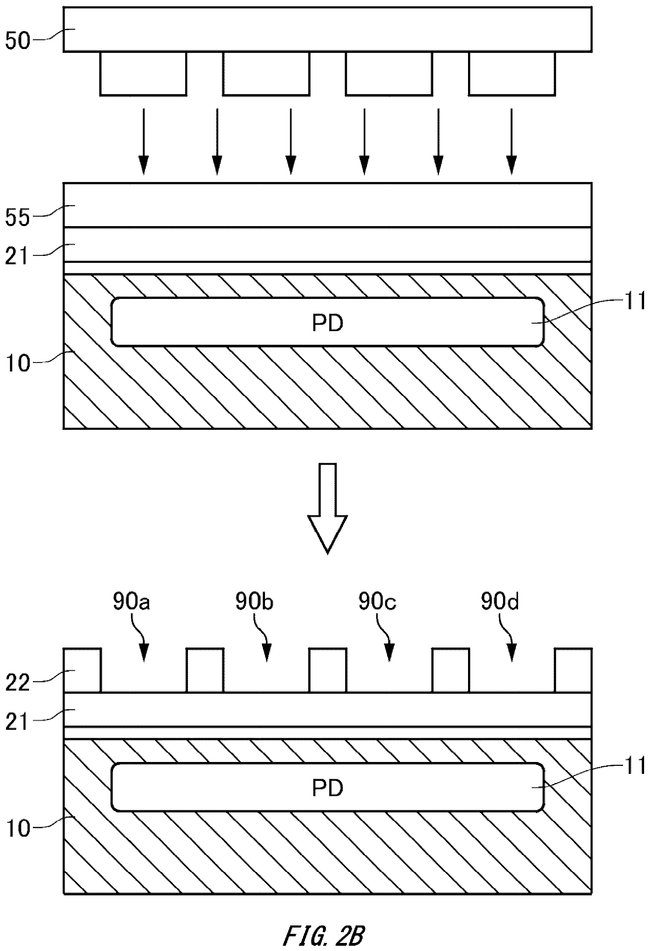

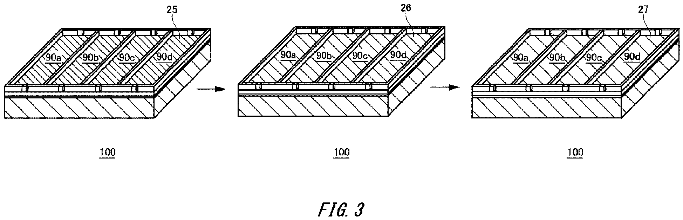

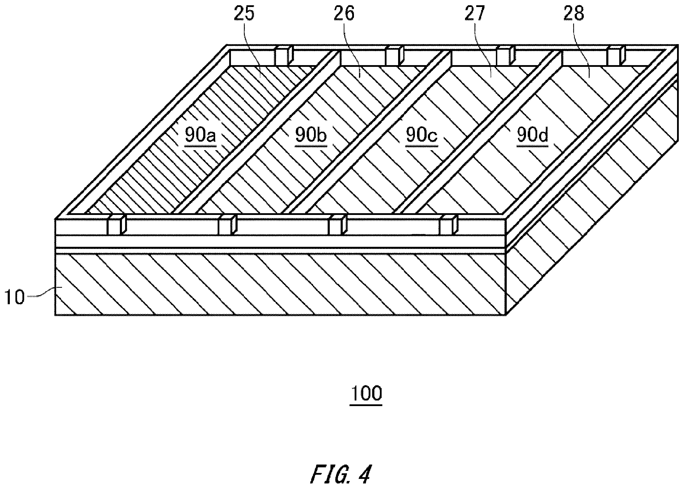

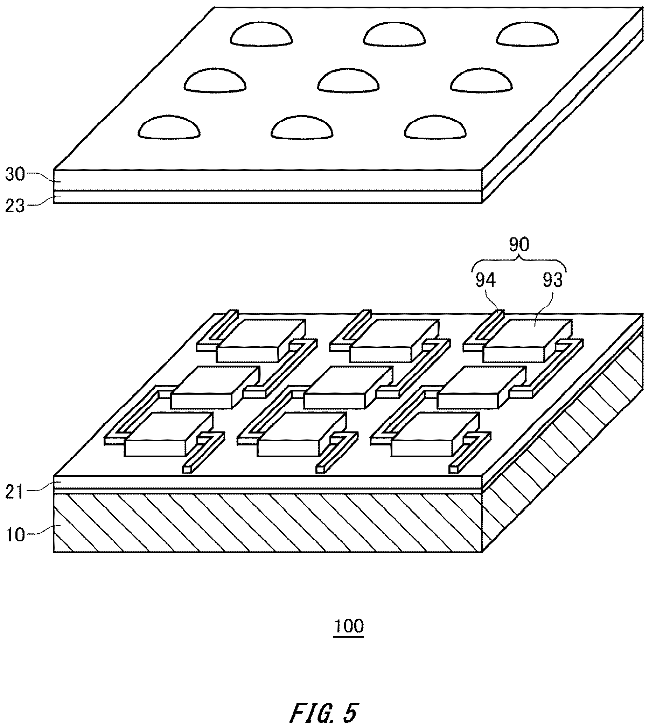

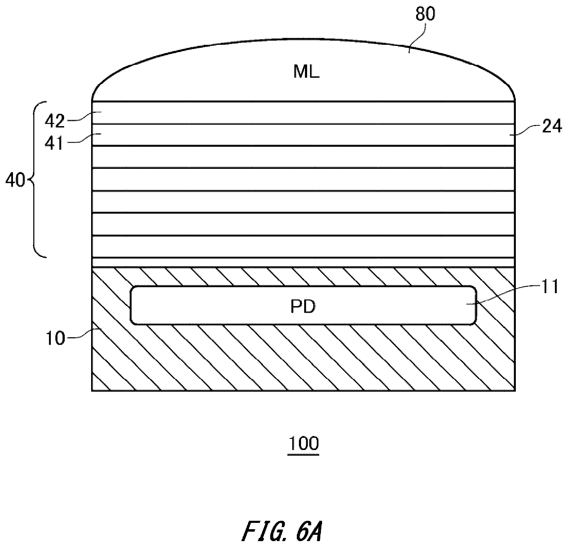

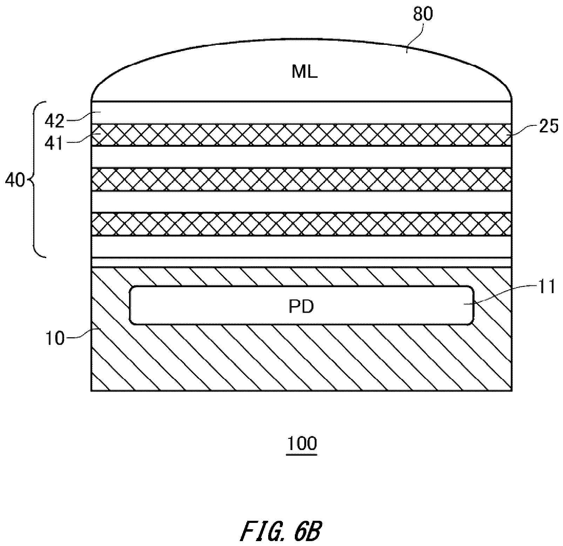

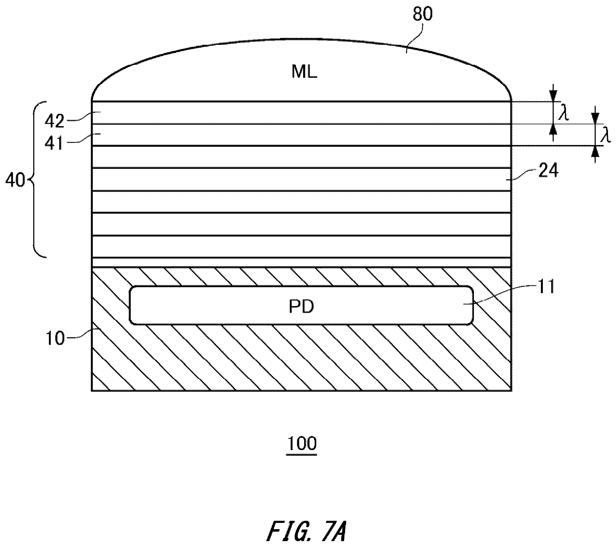

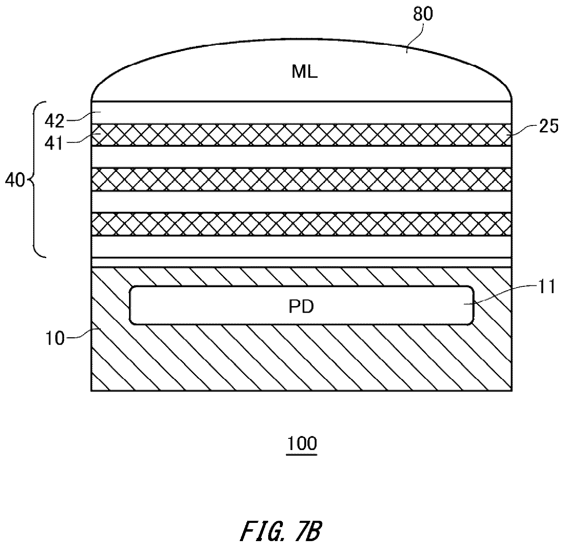

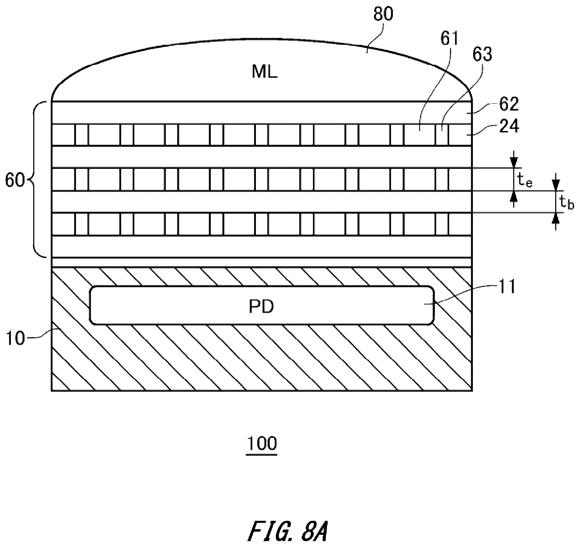

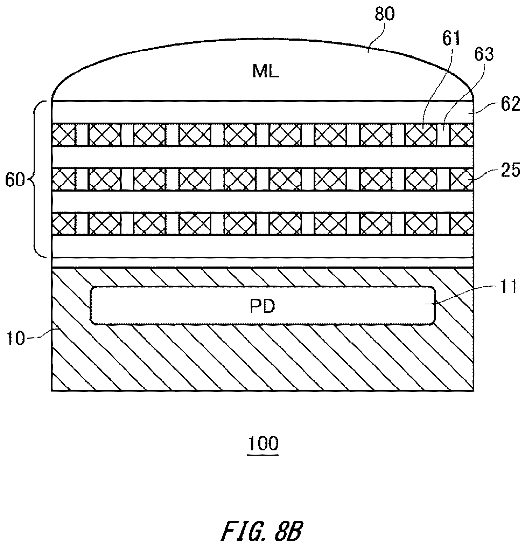

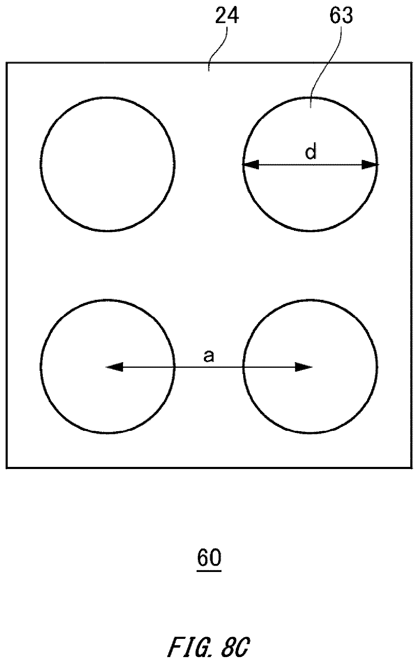

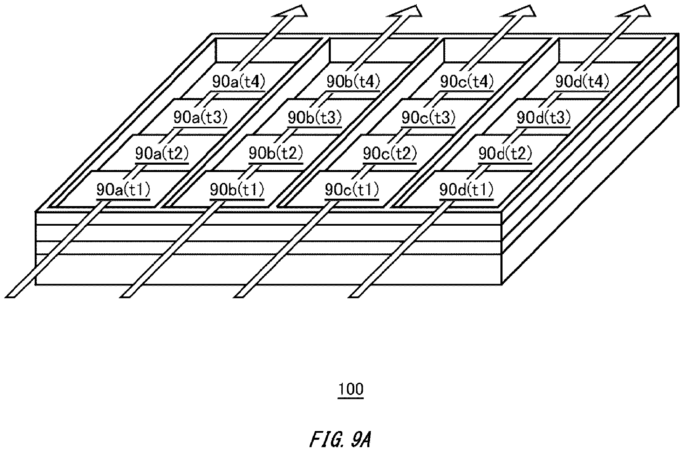

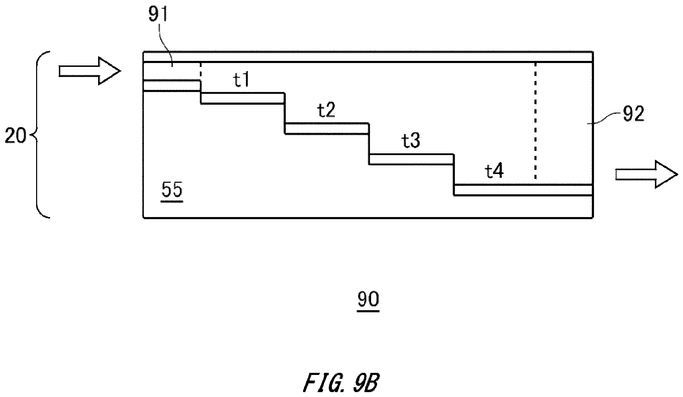

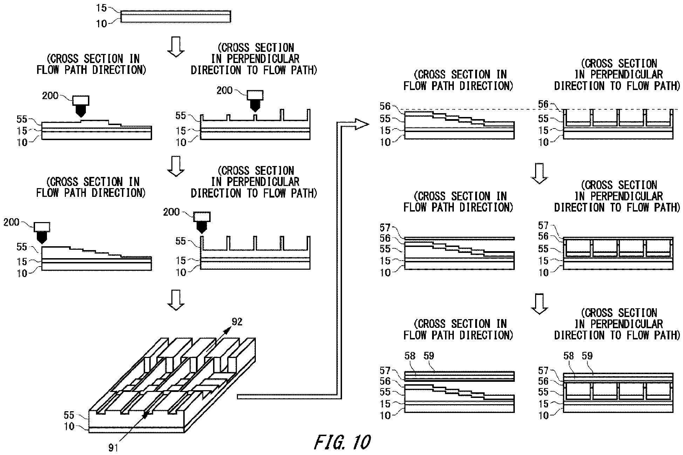

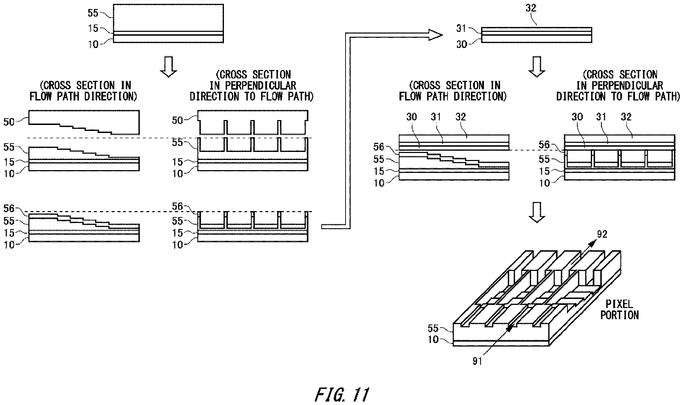

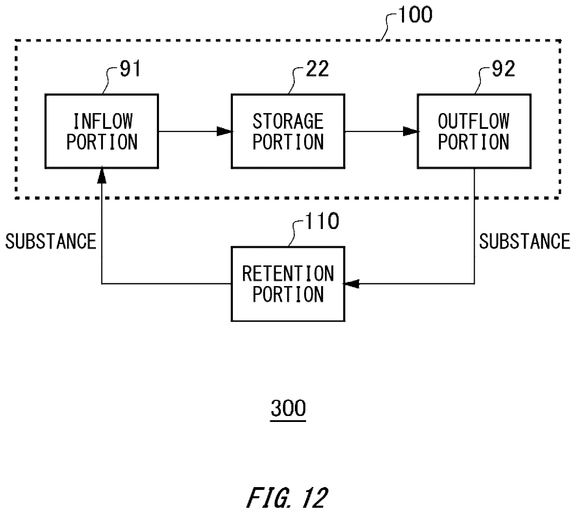

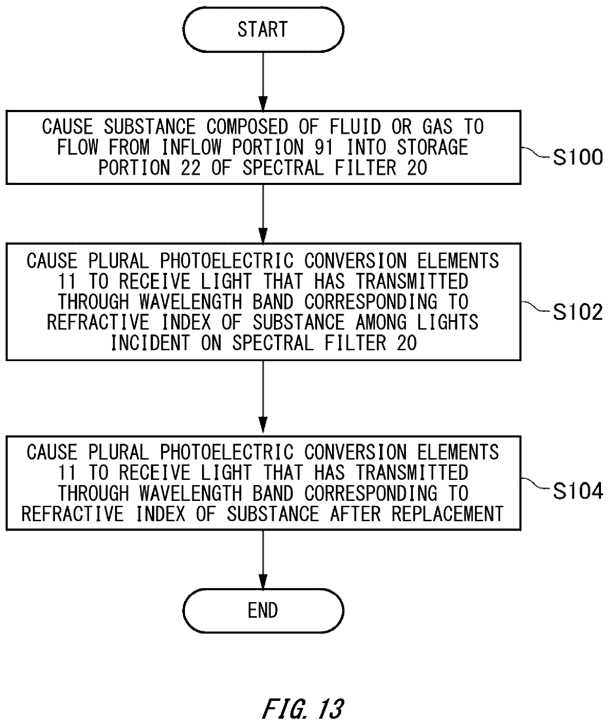

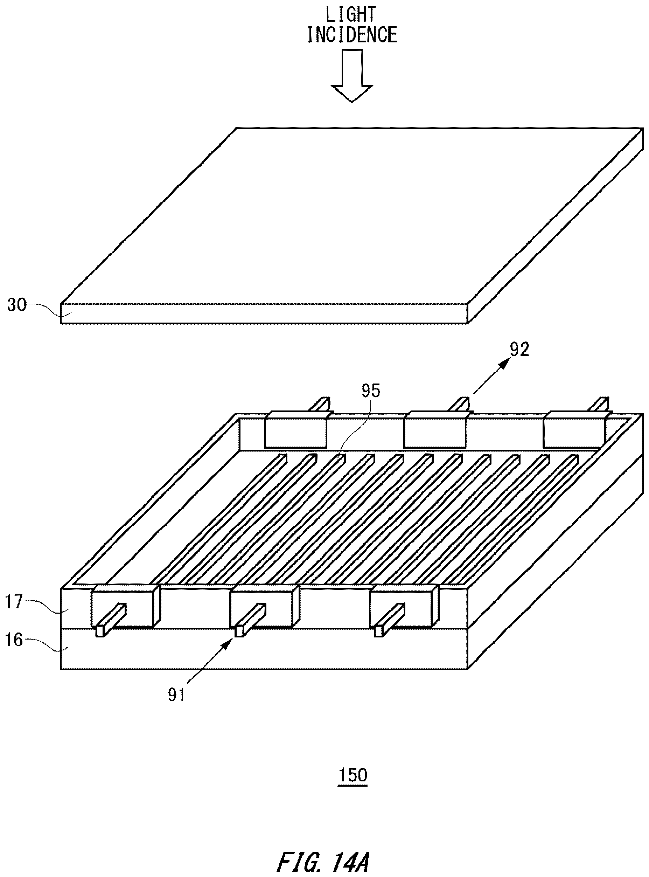

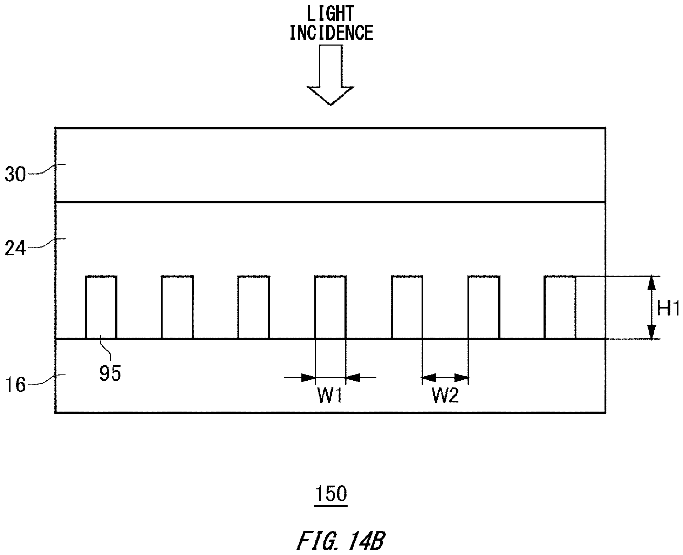

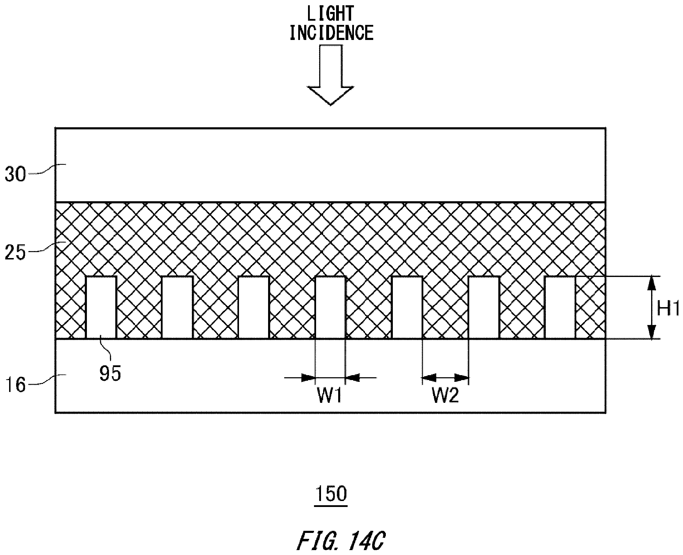

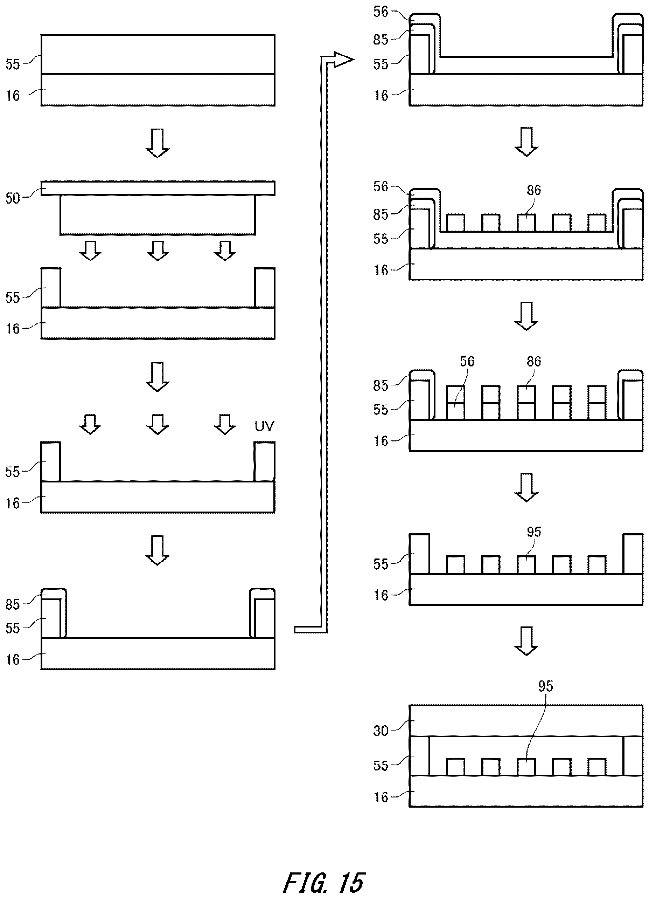

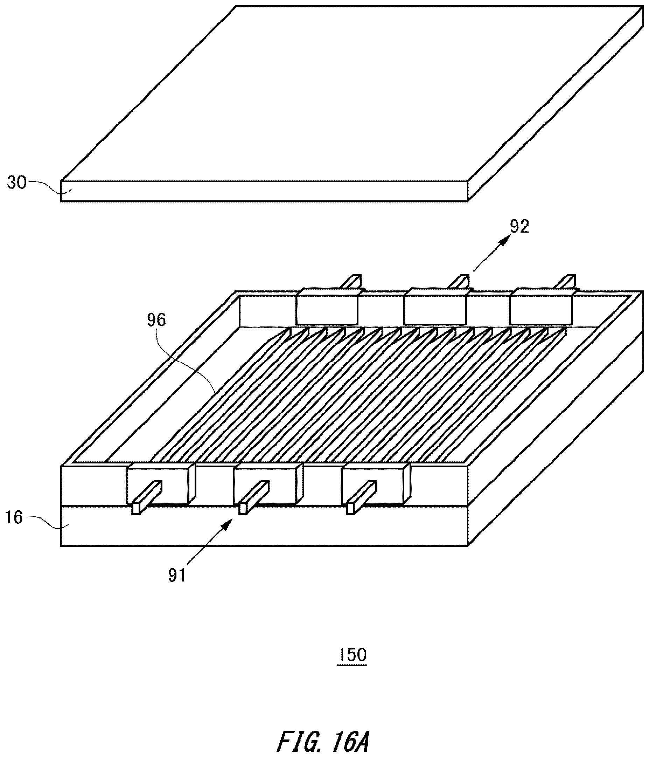

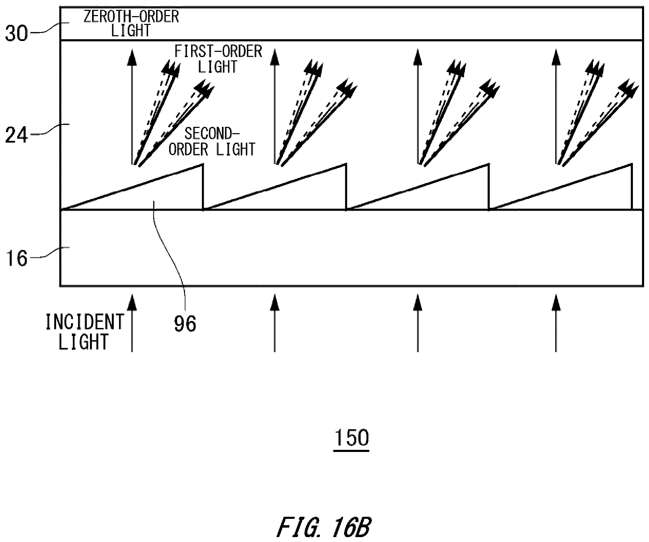

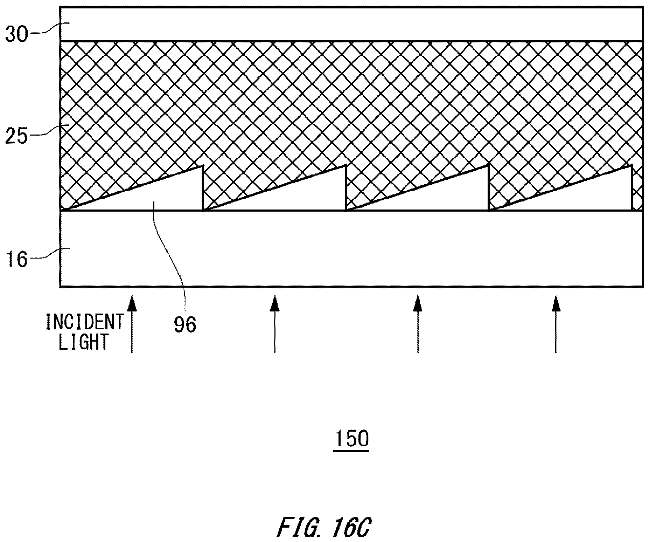

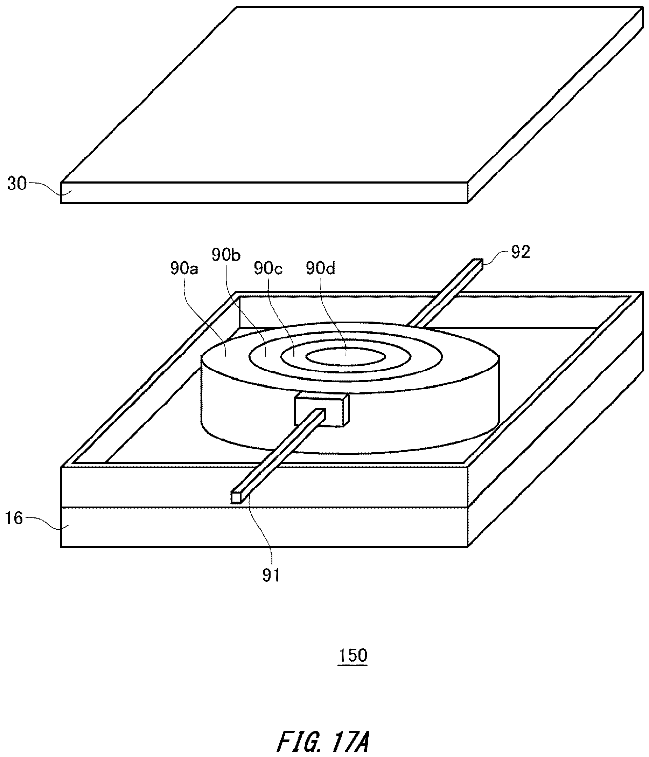

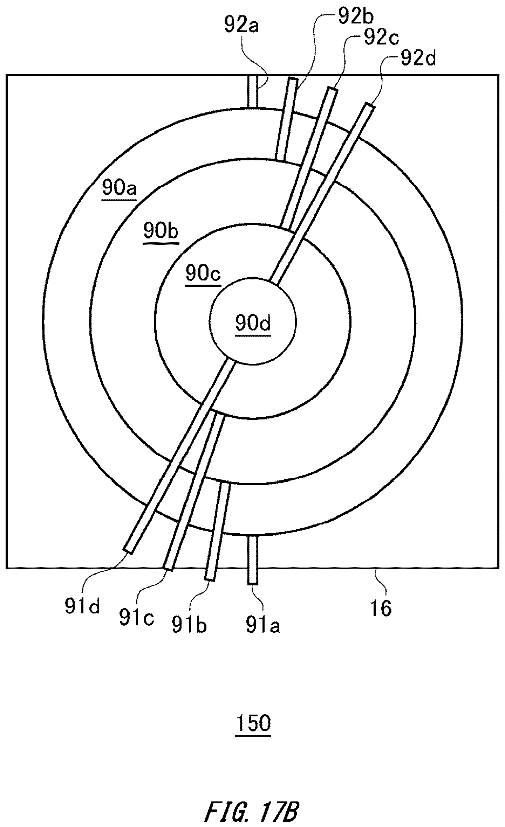

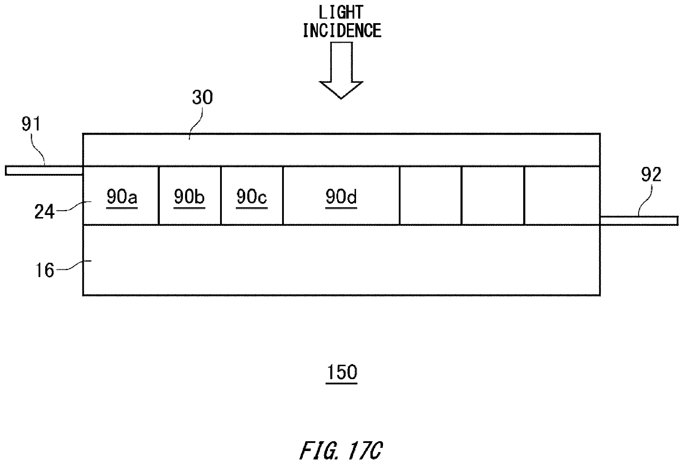

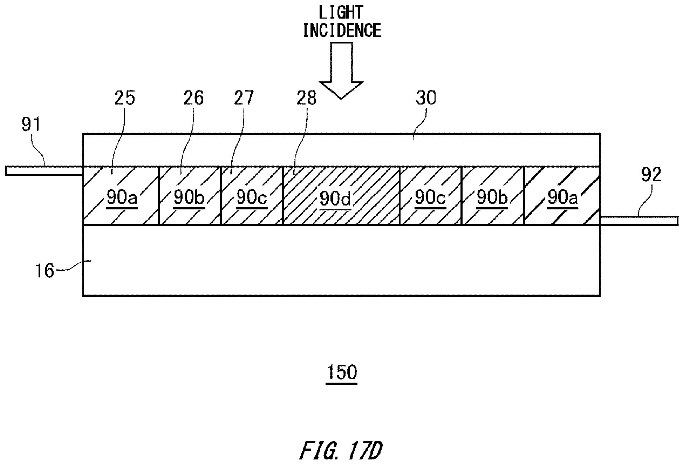

FIG. 1A illustrates an example of a configuration of an imaging device 100 according to Embodiment 1. FIG. 1B illustrates an example of the configuration of the imaging device 100 according to Embodiment 1. FIG. 2A illustrates an example of the configuration of the imaging device 100 according to Embodiment 2. FIG. 2B illustrates an example of a forming method for a flow path 90 of the imaging device 100 according to Embodiment 2. FIG. 3 illustrates an example of an operation of the imaging device 100 according to Embodiment 2. FIG. 4 illustrates an example of the operation of the imaging device 100 according to Embodiment 2. FIG. 5 illustrates an example of the configuration of the imaging device 100 according to Embodiment 3. FIG.6A illustrates an example of the configuration of the imaging device 100 according to Embodiment 4. FIG. 6B illustrates an example of the configuration of the imaging device 100 according to Embodiment 4. FIG. 7A illustrates an example of the configuration of the imaging device 100 according to Embodiment 5. FIG. 7B illustrates an example of the configuration of the imaging device 100 according to Embodiment 5. FIG. 8A illustrates an example of the configuration of the imaging device 100 according to Embodiment 6. FIG. 8B illustrates an example of the configuration of the imaging device 100 according to Embodiment 6. FIG.8C is an expanded view of a structure of a pillar layered portion 60 according to Embodiment 6. FIG. 9A illustrates an example of the configuration of the imaging device 100 according to Embodiment 7. FIG. 9B illustrates an example of a cross sectional view of the imaging device 100 according to Embodiment 7. FIG. 10 illustrates an example of a fabrication method for the imaging device 100 according to Embodiment 7. FIG. 11 illustrates an example of the fabrication method for the imaging device 100 according to Embodiment 7. FIG. 12 illustrates an outline of a configuration of an imaging apparatus 300. FIG. 13 illustrates an example of an imaging method using the imaging device 100. FIG. 14A illustrates an example of a configuration of an optical element 150 according to Embodiment 8. FIG. 14B illustrates an example of a cross sectional view of the optical element 150 according to Embodiment 8. FIG. 14C illustrates an example of the cross sectional view of the optical element 150 according to Embodiment 8. FIG. 15 illustrates an example of a fabrication method for the optical element 150 according to Embodiment 8. FIG. 16A illustrates an example of the configuration of the optical element 150 according to Embodiment 9. FIG. 16B illustrates an example of the cross sectional view of the optical element 150 according to Embodiment 9. FIG. 16C illustrates an example of the cross sectional view of the optical element 150 according to Embodiment 9. FIG. 17A illustrates an example of the configuration of the optical element 150 according to Embodiment 10. FIG. 17B illustrates an example of a plan view of the optical element 150 according to Embodiment 10. FIG. 17C illustrates an example of a cross sectional view of the optical element 150 according to Embodiment 10. FIG. 17D illustrates an example of the cross sectional view of the optical element 150 according to Embodiment 10.

### DESCRIPTION OF EXEMPLARY EMBODIMENTS

Hereinafter, the present invention will be described by way of embodiments of the invention, but the following embodiments are not intended to limit the invention according to the scope of the claims. In addition, not all combinations of features described in the embodiments necessarily have to be essential to solving means of the invention.

### [Embodiment 1]

FIG. 1A and FIG. 1B illustrate an example of a configuration of an imaging device 100 according to Embodiment 1. The imaging device 100 in this example includes a light receiving portion 10, a spectral filter 20, and a glass substrate 30. In FIG. 1A and FIG. 1B, substances with which the spectral filter 20 is filled are different from each other.

The light receiving portion 10 includes a semiconductor substrate. The light receiving portion 10 in this example includes a plurality of photoelectric conversion elements 11 arranged in a two-dimensional manner. The photoelectric conversion element 11 receives light incident on the light receiving portion 10.

The spectral filter 20 is a filter based on a Fabry-Perot interference film method which transmits light having a predetermined wavelength. The spectral filter 20 transmits light in a wavelength band corresponding to a refractive index of a stored substance. The spectral filter 20 is joined onto the light receiving portion 10. The spectral filter 20 is provided to correspond to one or more of the photoelectric conversion elements 11 arranged in a two-dimensional manner. The spectral filter 20 includes a mirror 21, a storage portion 22, and a mirror 23. The spectral filter 20 stores a plurality of substances having different refractive indices by way of replacement. In one example, the spectral filter 20 replaces a first substance having a first refractive index with a second substance having a second refractive index. For example, the first substance is air, and the second substance is a fluid. According to this, the spectral filter 20 switches a spectral characteristic from a first spectral characteristic to a second spectral characteristic. It is noted that the spectral characteristic includes an optical characteristic (transmittance spectrum) indicating a transition of a transmittance of light with respect to change in a wavelength. The imaging device 100 in this example can switch any one of a wavelength band in which light transmits (range between a shortest wavelength and a longest wavelength in which the transmittance is higher than or equal to a predetermined threshold), an off-band characteristic (wavelength band in which the transmittance is lower than the predetermined threshold), a peak wavelength, a transmittance at the peak wavelength, and a transmittance spectrum shape itself, or a combination of these as the spectral characteristic. It is noted however that a specific item of the spectral characteristic is not limited to this. In this manner, the spectral filter 20 filters multi-band light.

The storage portion 22 is each provided for one or more of the photoelectric conversion elements 11, and stores a substance composed of a fluid or a gas. The storage portion 22 is sandwiched by the mirror 21 and the mirror 23 serving as a pair of mutually facing reflective surfaces. The mirror 21 and the mirror 23 in this example contain Ag and Al₂O₃. The storage portion 22 includes an inflow portion through which the substance flows into the storage portion 22, and an outflow portion through which the substance flows out from the storage portion 22. For example, in a state where a substance 24 is stored, the storage portion 22 causes the substance 24 to flow out from the outflow portion. Then, the storage portion 22 causes a substance 25 to flow in from the inflow portion. In this manner, the substance to be stored in the storage portion 22 is replaced.

The storage portion 22 has a film thickness of a thickness d. For example, in a case where the storage portion 22 stores a substance having a refractive index n, an optical film thickness of the storage portion 22 (that is, the refractive index × the film thickness) becomes nd. The peak wavelength of the transmitted light shifts in accordance with the optical film thickness of the storage portion 22. For example, in a case where the optical film thickness of the storage portion 22 is equal to an integral multiple of λ/2, light around the wavelength λ transmits through the storage portion 22. In FIG. 1A, the storage portion 22 stores the substance 24, and in FIG. 1B, the storage portion 22 stores the substance 25. The substance 24 and the substance 25 are substances having mutually different refractive indices.

The substance 24 has the predetermined first refractive index. The substance 24 in this example is a gas. For example, the substance 24 is air. The substance 24 is an example of the first substance.

The substance 25 has the second refractive index corresponding to a refractive index higher than the substance 24. The substance 25 in this example is a fluid. The substance 25 is an example of the second substance. It is noted that the substance 24 and the substance 25 may also be both gases or may also be both fluids. That is, the substance 24 and the substance 25 may be substances having mutually different refractive indices.

The glass substrate 30 is joined onto the spectral filter 20. The glass substrate 30 may allow transmission of the incident light to be incident on the spectral filter 20. It is noted that, incident medium on the glass substrate 30 may be air.

In one example of the spectral filter 20, with regard to each of the mirror 21 and the mirror 23, a film thickness of Ag is set as 25 nm, a film thickness of Al₂O₃ is set as 70 nm, and the thickness d of the storage portion 22 is set as 200 nm. Herein, when air having a refractive index of 1 is stored in the storage portion 22 as an example of the first substance, the spectral filter 20 is set to have a spectral characteristic in which a band between a wavelength of 400 nm (transmittance 10% or higher) and a wavelength of 750 nm (transmittance 1% or higher) is set as a transmission wavelength band, and a peak wavelength is approximately 500 nm. In addition, when water having a refractive index of 1.33 is stored in the storage portion 22 as an example of the second substance, the spectral filter 20 is set to have a spectral characteristic in which a wavelength band similar to the case where air is stored in the storage portion 22 is set, and a peak wavelength is approximately 667 nm.

In this manner, the imaging device 100 in this example changes the optical film thickness of the storage portion 22 by replacing the substance to be stored in the storage portion 22. According to this, the imaging device 100 changes the spectral characteristic for the transmitting light among the lights incident on the storage portion 22. Thus, multi-bands in the imaging device 100 are realized.

### [Embodiment 2]

FIG. 2A illustrates an example of the configuration of the imaging device 100 according to Embodiment 2. The spectral filter 20 in this example includes a plurality of flow paths 90 through which the substance to be stored in the storage portion 22 flows.

The flow path 90 includes four flow paths 90a to 90d. The flow paths 90a to 90d have a linear separation structure in which each of the flow paths extends in a linear manner and respectively store substances. That is, the flow paths 90a to 90d respectively correspond to the storage portions. The respective flow paths 90 in this example are provided to correspond to the photoelectric conversion elements 11. The flow path 90 includes an inflow portion 91 and an outflow portion 92 on both ends. An inlet that allows inflow of the substance is provided in the inflow portion 91, and an outlet that allows outflow of the substance is provided in the outflow portion 92.

In addition, each of the flow paths 90a to 90d in this example has a same structure. That is, depths and lengths of the respective flow paths 90a to 90d are equal to one another. It is noted however that shapes of the respective flow paths 90a to 90d may also be different from one another. In this case, even in a case where substances having a same refractive index are stored, the wavelength bands of the flow paths 90a to 90d can be changed.

The glass substrate 30 is joined to the spectral filter 20. The glass substrate 30 in this example is laminated on the mirror 23. The glass substrate 30 includes a plurality of lens portions. The plurality of lens portions may be respectively provided to correspond to the photoelectric conversion elements 11.

FIG. 2B illustrates an example of a forming method for the flow path 90 of the imaging device 100 according to Embodiment 2. The flow path 90 in this example is formed in resin 55 using a nano-imprint method.

A mold 50 has a pattern in accordance with a shape of the flow path 90. For example, the mold 50 includes a convex portion in accordance with a concave portion of the flow path 90. When the mold 50 is pressed against the resin 55, a line structure of the flow path 90 is formed in the resin 55.

The resin 55 is provided on the mirror 21. The resin 55 is deformed by being pressed against by the mold 50. According to this, the concave portion in accordance with the flow path 90 is formed in the resin 55. After the concave portion of the flow path 90 is formed, the mold 50 may be released from the resin 55. In one example, the resin 55 is cured by ultraviolet (UV) irradiation or heating.

In this example, a case where the flow path 90 is formed using the nano-imprint method has been described, but the flow path 90 can be formed also by using other process. The concave portion of the flow path 90 may also be formed by etching process in the resin 55.

FIG. 3 illustrates an example of an operation of the imaging device 100 according to Embodiment 2. The imaging device 100 in this example causes substances having different refractive indices to flow through the flow paths 90 in a time division manner. The imaging device 100 in this example realizes multi-bands using a wavelength sweeping method.

The imaging device 100 causes the flow paths 90a to 90d to change the refractive indices of the substances to be stored for each frame. The imaging device 100 in this example uses three substances 25 to 27 having different refractive indices. For example, in the imaging device 100, the substance 25 is stored in the flow paths 90a to 90d at a predetermined first point in time. That is, the same substance 25 is stored in all the flow paths 90a to 90d. Next, at a second point subsequent to the first point in time, after outflow of the substance 25 from the flow paths 90a to 90d, the substance 26 is stored in the flow paths 90a to 90d. Then, at a third point subsequent to the second point in time, after outflow of the substance 26 from the flow paths 90a to 90d, the substance 27 is stored in the flow paths 90a to 90d. According to this, the imaging device 100 in this example can change the light receiving wavelength band to a plurality of wavelength bands in accordance with the plurality of substances stored in the flow paths 90. It is noted that, in this example, the case has been described where the three substances including the substances 25 to 27 are used, but four or more substances may also be used.

As described above, the imaging device 100 in this example can receive the light in the wavelength band previously set for each frame. In addition, the imaging device 100 can receive the lights in the plurality of wavelength bands by merely changing the substance to be stored in the flow paths 90 without changing the shapes of the flow paths 90. According to this, the imaging device 100 realizes multi-bands without complicating the structure.

FIG. 4 illustrates an example of the operation of the imaging device 100 according to Embodiment 2. In the imaging device 100 in this example, substances having different refractive indices are stored in the flow paths 90a to 90d. The imaging device 100 in this example realizes multi-bands using a line scanning method.

In the imaging device 100, the substances having the different refractive indices are stored in the flow paths 90a to 90d for each line (that is, a row or a column) . For example, the flow paths 90a to 90d respectively store substances 25 to 28. According to this, the flow paths 90a to 90d respectively allow transmission of lights in different wavelength bands. Then, the plurality of photoelectric conversion elements 11 corresponding to the flow paths 90a to 90d respectively receive the lights in the different wavelength bands.

As described above, in the imaging device 100 in this example, the substances having the different refractive indices are respectively stored in the flow paths 90a to 90d at a same point in time. For this reason, the imaging device 100 can simultaneously receive the lights in the plurality of wavelength bands. In addition, since the imaging device 100 in this example does not need to replace the substances to be stored in the flow paths 90a to 90d, power for replacing the substance is not consumed.

It is noted that, in this example, the case has been described where the four substances including the substances 25 to 28 are used, but five or more substances may also be used. In addition, the imaging device 100 may also replace the substances to be stored in the flow paths 90 with substances having respectively different refractive indices. Specifically, at the predetermined first point in time, the substances 25 to 28 are stored in the flow paths 90a to 90d. Next, at the second point subsequent to the first point in time, after outflow of the substances 25 to 28 from the flow paths 90a to 90d, the substances 25 to 28 are stored in flow paths adjacent to the flow paths 90a to 90d where the substances are stored so far. That is, the substance 26, the substance 27, the substance 28, and the substance 25 are stored in the flow paths 90a to 90d in the stated order. When this is repeatedly performed, a multi-band image is obtained each time imaging is performed in the imaging device 100, and also multi-bands in the same photoelectric conversion element 11 can also be realized in a time division manner. Furthermore, the imaging device 100 may perform capturing while a subject is moved by a belt conveyor or the like. According to this, it is possible to obtain data in accordance with the respective transmission wavelength bands of the flow paths 90a to 90d at once.

### [Embodiment 3]

FIG. 5 illustrates an example of the configuration of the imaging device 100 according to Embodiment 3. The imaging device 100 in this example includes the flow path 90 between the mirror 21 and the mirror 23. The flow path 90 includes a hollow portion 93 and a connecting portion 94.

An inside of the hollow portion 93 is hollow in which a substance having a predetermined refractive index is stored. That is, the hollow portion 93 corresponds to the storage portion. In one example, a shape of the hollow portion 93 is a rectangular parallelepiped. The imaging device 100 in this example includes a plurality of the hollow portions 93. The plurality of hollow portions 93 are respectively arranged to correspond to the photoelectric conversion elements 11. One or more substances may be stored in the hollow portion 93.

The connecting portion 94 connects the plurality of hollow portions 93 to each other. The connecting portion 94 in this example connects the plurality of hollow portions 93 to each other in a predetermined column direction. According to this, a line is formed by connecting the plurality of hollow portions 93 to each other by the connecting portion 94. In addition, a plurality of the lines formed by connecting the plurality of hollow portions 93 to each other by the connecting portion 94 are arranged in a predetermined row direction. An inside of the connecting portion 94 is hollow, and the substance flows between the plurality of connected hollow portions 93.

The imaging device 100 in this example causes a predetermined substance to flow for each line obtained by connecting the plurality of hollow portions 93 to each other by the connecting portion 94. The imaging device 100 may also cause substances having different refractive indices to flow for each line. In addition, the imaging device 100 may also cause substances having different refractive indices to flow for each frame (that is, in a time division manner). In the imaging device 100 in this example, the hollow portions 93 are arranged to correspond to the photoelectric conversion elements 11, and areas other than areas where the photoelectric conversion elements 11 are provided are connected to each other by the connecting portion 94. According to this, the imaging device 100 in this example can reduce the amount of the substance flowing through the flow path 90 as compared with the case according to Embodiment 2. According to this, the replacement of the substance flowing through the flow path 90 is facilitated.

### [Embodiment 4]

FIG. 6A and FIG. 6B illustrate an example of the configuration of the imaging device 100 according to Embodiment 4. The imaging device 100 in this example includes a multilayer interference film 40 as the spectral filter 20.

The multilayer interference film 40 is an interference filter constituted by a laminated structure including a low refractive index layer and a high refractive index layer. The multilayer interference film 40 in this example includes a storage portion 41 as the low refractive index layer, and a base material 42 as the high refractive index layer. The multilayer interference film 40 in this example realizes a plurality of wavelength bands by changing refractive indices by using substances stored in the storage portions 41. It is noted that the multilayer interference film 40 may also function as a color filter that transmits light in a predetermined wavelength band.

The storage portion 41 is each provided for one or more of the photoelectric conversion elements 11, and stores a substance composed of a fluid or a gas. The storage portion 41 includes an inflow portion and an outflow portion, and realizes a plurality of wavelength bands by replacing the substance to be stored. With reference to FIG. 6A, the substance 24 having a predetermined refractive index is stored in the storage portion 41. On the other hand, with reference to FIG. 6B, the substance 25 having a refractive index different from the refractive index of the substance 24 is stored in the storage portion 41. For example, any one of air having the refractive index of 1 and water having the refractive index of 1.33 is stored in the storage portion 41, and these substances are replaced using the inflow portion and the outflow portion. It is noted however that the substances to be stored in the storage portion 41 are not limited to these.

The base material 42 has a third refractive index different from the refractive index of the substance stored in the storage portion 41. The refractive index of the base material 42 is higher than the refractive index of the substance stored in the storage portion 41. The base materials 42 are provided while sandwiching the storage portion 41. That is, the base materials 42 are provided on both ends of the multilayer interference film 40. Since the base materials 42 are provided while sandwiching the storage portion 41, a predetermined substance is stored in the storage portion 41. The multilayer interference film 40 changes a transmission band of the multilayer interference film 40 by replacing the substance to be stored in the storage portion 41. For example, the base material 42 is formed of SiN having a refractive index of 2.0, or the like. It is noted however that the material of the base material 42 is not limited to this.

A lens portion 80 is formed above the multilayer interference film 40. The lens portion 80 is joined on a side opposite to a side where the light receiving portion 10 is joined in the multilayer interference film 40. A plurality of the lens portions 80 may be provided to correspond to the plurality of photoelectric conversion elements 11.

As described above, the imaging device 100 in this example realizes multi-bands by replacing the substance to be stored in the storage portion 41 of the multilayer interference film 40. In this manner, the imaging device 100 can also realize multi-bands in the interference filter constituted by the laminated structure including the low refractive index layer and the high refractive index layer.

### [Embodiment 5]

FIG. 7A and FIG. 7B illustrate an example of the configuration of the imaging device 100 according to Embodiment 5. The imaging device 100 in this example includes the multilayer interference film 40 in which the storage portion 41 and the base material 42 are laminated in multiple layers as the spectral filter 20.

The multilayer interference film 40 reflects or transmits light in a predetermined wavelength band. The multilayer interference film 40 in this example switches a reflection filter and a transmission filter by replacing the substance to be stored in the storage portion 41. In one example, the multilayer interference film 40 in this example functions as a monochromatic reflection filter that reflects part of wavelength bands among wavelength bands in which the photoelectric conversion element 11 has sensitivity, and transmits the other lights. Furthermore, the multilayer interference film 40 also functions as a transmission filter that transmits the entire wavelength bands among the wavelength bands in which the photoelectric conversion element 11 has sensitivity.

The storage portion 41 has a thickness equal to a wavelength λ of incident light. The storage portion 41 in this example replaces the substance to be stored with a gas and a fluid. With reference to FIG. 7A, the substance 24 corresponding to a gas is stored in the storage portion 41. On the other hand, with reference to FIG. 7B, the substance 25 corresponding to a fluid is stored in the storage portion 41. In one example, the refractive index of the substance 25 is the same as the refractive index of the base material 42. For example, the substance 24 is air having the refractive index of 1, and the substance 25 is water having the refractive index of 1.33. The base material 42 is formed of MgF₂ having a refractive index of approximately 1.3 that is the same level as water. It is noted however that the substance stored in the storage portion 41 and the material of the base material 42 are not limited to these.

The base material 42 has a thickness equal to the wavelength λ of the incident light. That is, the storage portion 41 and the base material 42 have a repeated structure of an optical path length 1λ. According to this, the multilayer interference film 40 in this example functions as a reflection filter for a specific wavelength λ. It is noted that, in one example, the specific wavelength λ indicates a wavelength band in a narrow band corresponding to a half width (for example, approximately 10 nm to approximately 50 nm) where the half width is previously set while the wavelength λ is set as a center.

Herein, the multilayer interference film 40 includes different functions at the time of filling with air and the time of filling with a fluid. For example, the multilayer interference film 40 functions as the reflection filter for the specific wavelength λ in a case where the substance 24 corresponding to the gas is stored in the storage portion 41. On the other hand, the multilayer interference film 40 functions as the transmission filter for the wavelength band in which the photoelectric conversion element 11 can receive light in a case where the substance 25 corresponding to the fluid is stored in the storage portion 41.

As described above, the imaging device 100 in this example functions as the reflection filter or the transmission filter by replacing the substance to be stored in the storage portion 41 with the air and the fluid. In this manner, the imaging device 100 controls the reflection characteristic and the transmittance characteristic of the multilayer interference film 40 by replacing the substance to be stored.

### [Embodiment 6]

FIG. 8A and FIG. 8B illustrate an example of the configuration of the imaging device 100 according to Embodiment 6. FIG. 8C is an expanded view of a structure of a pillar layered portion 60 according to Embodiment 6. The imaging device 100 in this example includes the pillar layered portion 60 as the spectral filter 20.

The pillar layered portion 60 reflects or transmits light in a predetermined wavelength band. The pillar layered portion 60 has a layered structure including a storage portion 61 and a base material 62. The pillar layered portion 60 in this example switches a reflection filter and a transmission filter by replacing the substance to be stored in the storage portion 61. In one example, the pillar layered portion 60 in this example functions as a monochromatic reflection filter, and also functions as a transmission filter.

The storage portion 61 is each provided for one or more of the photoelectric conversion elements 11, and stores a substance composed of a fluid or a gas. The storage portion 61 includes an inflow portion and an outflow portion, and realizes a plurality of wavelength bands by replacing the substance to be stored. With reference to FIG. 8A, the substance 24 corresponding to the gas is stored in the storage portion 61. On the other hand, with reference to FIG. 8B, the substance 25 corresponding to the fluid is stored in the storage portion 61. The storage portion 61 in this example has a thickness tₑ.

The base material 62 has the third refractive index different from the refractive index of the substance stored in the storage portion 61. The refractive index of the base material 62 is higher than the refractive index of the substance stored in the storage portion 61. The base material 62 is an example of the high refractive index layer. The base material 62 in this example has a thickness t_{b}. For example, the base material 62 is formed of SiO₂ having a refractive index of 1.5.

A plurality of pillars 63 are provided inside a hollow of the storage portion 61. The pillar 63 has a refractive index different from the refractive index of the base material 62. The pillar 63 in this example has the refractive index higher than the base material 62. For example, the pillar 63 is formed of Al₂O₃ having a refractive index of 1.8. The pillar 63 in this example has a cylindrical shape.

Herein, when the plurality of pillars 63 are arranged in a period lower than or equal to a wavelength of light incident on the pillar layered portion 60, an effective refractive index of the storage portion 61 is changed. For example, the effective refractive index is changed in accordance with an area ratio between the plurality of pillars 63 and the substance stored in the storage portion 61. A pitch a between the pillar 63 indicates an interval between mutual centers of the adjacent pillars 63. The pitch a may be decided in accordance with the wavelength of the incident light and the effective refractive index of the pillar layered portion 60. A diameter d indicates a diameter of a cross section of the base material 62. It is noted that a cross sectional shape of the pillar 63 in this example is a circular shape, but may also be a triangular shape or other polygonal shapes such as a quadrangular shape. In addition, the pillar 63 in this example is a circular cylinder, but a taper may also be provided. In this manner, the pillar layered portion 60 adjusts the wavelength band in which transmission occurs through the pillar layered portion 60 on the basis of the shape and arrangement of the pillars 63.

Therefore, the pillar layered portion 60 can adjust the transmittance characteristic and the reflection characteristic in accordance with the substance to be stored in the storage portion 61. For example, the pillar layered portion 60 functions as the reflection filter for the specific wavelength band in a case where the substance 24 corresponding to the gas is stored in the storage portion 61. On the other hand, the pillar layered portion 60 functions as the transmission filter for the specific wavelength band in a case where the substance 25 corresponding to the fluid is stored in the storage portion 61.

In one example of the spectral filter 20, the thickness t_{b} of the base material 62 formed of SiO₂ is set as 200 nm, the thickness tₑ of the storage portion 61 is set as 236 nm, the diameter d of the pillar 63 is set as 136 nm, and the pitch a between the mutual centers of the pillars 63 is set as 200 nm. Herein, when air having the refractive index of 1 as an example of a gas is stored in the storage portion 61, the effective refractive index of the storage portion 61 including the pillars 63 becomes approximately 1.27, which allows the pillar layered portion 60 to function as the reflection filter that reflects light having the specific wavelength λ of approximately 600 nm. In addition, when water having the refractive index of 1.33 is stored in the storage portion 61 as an example of the fluid, the effective refractive index of the storage portion 61 including the pillars 63 becomes approximately 1.49 and does not differ from the refractive index of the base material 62, which allows the pillar layered portion 60 to function as the transmission filter that transmits the incident light.

As described above, the imaging device 100 includes the plurality of pillars 63 arranged at a predetermined interval. The imaging device 100 in this example can freely design the transmittance characteristic and the reflection characteristic of the pillar layered portion 60 in accordance with the pitch between the pillars 63, refractive indices of respective members, a size of the pillars 63, or the like. Therefore, it is easy to perform structural design in accordance with the substance to be stored in the storage portion 61 with regard to the imaging device 100 in this example.

It is noted that the spectral filters 20 may include the pillar 63 having a different cross sectional area in the array direction of the photoelectric conversion elements 11 for each of the storage portions 61 corresponding to one or more of the photoelectric conversion elements 11. According to this, it is possible to change a transmittance characteristic of the spectral filter 20 for each of the storage portions 61 corresponding to one or more of the photoelectric conversion elements 11.

### [Embodiment 7]

FIG. 9A illustrates an example of the configuration of the imaging device 100 according to Embodiment 7. FIG. 9B illustrates an example of a cross sectional view of the imaging device 100 according to Embodiment 7. The imaging device 100 in this example includes the flow path 90 provided with steps as the spectral filter 20. The flow path 90 corresponds to the storage portion. The imaging device 100 in this example is a filter based on the Fabry-Perot interference film method similarly as in Embodiment 1, and a pair of mirrors are arranged while sandwiching the flow path 90.

The spectral filter 20 is provided for each block constituted by a plurality of the photoelectric conversion elements 11. According to this, the plurality of photoelectric conversion elements 11 receive the multi-band light realized by the spectral filter 20. The inlet for allowing inflow of the substance from the inflow portion 91 into the storage portion 22 and the outlet for allowing outflow of the substance from the storage portion 22 to the outflow portion 92 are provided while facing each other with regard to the array direction of the photoelectric conversion elements 11 in the spectral filter 20 in this example.

The flow path 90 includes steps in the hollow in which the substance flows and has different thicknesses. The thickness of the flow path 90 may be an interval of the pair of reflective surfaces that sandwich the flow path 90. In one of the blocks of the photoelectric conversion elements 11, the thickness of the flow path 90 may each vary for one or more of the photoelectric conversion elements 11. That is, at least one photoelectric conversion element 11 is provided to correspond to each thickness of the flow path 90. The flow path 90 in this example has the interval that is gradually widened from the inlet of the inflow portion 91 towards the outlet of the outflow portion 92.

More specifically, the flow path 90 includes four flow paths 90a to 90d. In addition, the four flow paths including the flow paths 90a to 90d include regions having different spacer layer thicknesses. The flow paths 90a to 90d in this example respectively include four different spacer layer thicknesses t1 to t4. For example, the flow path 90a includes flow paths 90a(t1) to 90a(t4), the flow path 90b includes flow paths 90b(t1) to 90b(t4), the flow path 90c includes flow paths 90c(t1) to 90c(t4), and the flow path 90d includes flow paths 90d(t1) to 90d(t4). The spacer layer thicknesses t1 to t4 have a relationship of t1 < t2 < t3 < t4. For example, upper ends of the flow paths 90 are in the same plane, and lower ends of the flow paths 90 are gradually deepened in the regions having the thicknesses t1 to t4. According to this, the substance in the flow path 90 is facilitated to flow from the inflow portion 91 towards the outflow portion 92.

Herein, the imaging device 100 causes a substance having a different refractive index for each of the flow paths 90a to 90d to flow. For example, substances having refractive indices n1, n2, n3, and n4 respectively are caused to flow through the four flow paths 90a to 90d. The substances in this example have a relationship of n1 < n2 < n3 < n4. According to this, the imaging device 100 realizes 16 types of bands in totally based on the four refractive indices and the four spacer layer thicknesses.

It is noted that the imaging device 100 may also cause the same substance to flow through the flow paths 90a to 90d. In this case, four types of bands in accordance with the four spacer layer thicknesses are realized. The imaging device 100 can realize five or more types of bands by increasing the number of steps in the flow path 90.

FIG. 10 illustrates an example of a fabrication method for the imaging device 100 according to Embodiment 7. In this example, process flows based on an on-chip method will be described. According to the on-chip method, respective members are formed on a chip where the light receiving portion 10 is provided to fabricate the imaging device 100. In respective flows, cross sections in a flow path direction and cross sections in a direction perpendicular to the flow path are illustrated.

The light receiving portion 10 is prepared, and an oxide film 15 is formed on the light receiving portion 10. In addition, the resin 55 is applied onto the oxide film 15 by a three-dimensional (3D) printer 200. A hollow structure and an outer frame of the flow path 90 are formed using the resin 55. In a case where the 3D printer 200 is used, a step shape of the flow path 90 or the like can be freely selected. Furthermore, a metallic film 56 is formed on a top of the resin 55 by the 3D printer 200. Then, a lid structure made of resin 57 is formed by the 3D printer 200. A metallic film 58 and an oxide film 59 are formed on the resin 57 by a sputtering apparatus or the like. In this manner, the flow path 90 can be formed to have any shape by using the 3D printer 200.

FIG. 11 illustrates an example of the fabrication method for the imaging device 100 according to Embodiment 7. In this example, process flows based on a bonding method will be described. According to the bonding method, a substrate on a sensor side and the glass substrate 30 serving as a lid are bonded to each other to fabricate the imaging device 100. In respective flows, cross sections in the flow path direction and cross sections in a direction perpendicular to the flow path are illustrated.

The light receiving portion 10 provided for the substrate on the sensor side is prepared. The oxide film 15 and the resin 55 are formed on the light receiving portion 10. Thereafter, the hollow structure and the outer frame of the flow path 90 are formed by nanoimprint using the mold 50. Next, the resin 55 is cured by ultraviolet (UV) irradiation or heating. The metallic film 56 is formed on the resin 55.

On the other hand, the glass substrate 30 serving as the lid of the imaging device 100 is prepared. An oxide film 31 and a metallic film 32 are formed on the glass substrate 30. Then, the substrate on the sensor side and the glass substrate 30 are joined to each other. According to this, the flow path 90 including the inflow portions 91 and the outflow portions 92 is formed.

FIG. 12 illustrates an outline of a configuration of an imaging apparatus 300. The imaging apparatus 300 in this example includes the imaging device 100 and a retention portion 110.

The imaging device 100 includes the inflow portion 91, the storage portion 22, and the outflow portion 92. A predetermined substance flows into the storage portion 22 via the inflow portion 91. The substance stored in the storage portion 22 flows out to the retention portion 110 via the outflow portion 92.

The retention portion 110 is connected to the inflow portion 91 and the outflow portion 92, and retains the substance that has flown out from the storage portion 22. The retention portion 110 may retain a plurality of substances. The retention portion 110 causes the retained substance to flow into the inflow portion and causes the substance to be stored in the storage portion 22 again. The retention portion 110 may also allow the imaging device 100 to continuously perform inflow and outflow of the substance. In addition, the retention portion 110 may execute causing the substance to flow into the imaging device 100 and causing the substance to flow out from the imaging device 100 at a predetermined interval. In this case, power consumed in the retention portion 110 is reduced.

FIG. 13 illustrates an example of an imaging method using the imaging device 100. In this example, a transmittance characteristic of the imaging device 100 is controlled in steps S100 to S104.

In step S100, the substance composed of a fluid or a gas flows into the storage portion 22 of the spectral filter 20 from the inflow portion 91. In one example, a micro pump is used for the inflow of the substance into the storage portion 22.

In step S102, the plurality of photoelectric conversion elements 11 receive light that has transmitted through the wavelength band corresponding to the refractive index of the substance among lights incident on the spectral filter 20. For example, in step S102, the spectral filter 20 stores a fluid.

In step S104, the imaging device 100 causes the substance to flow out from the storage portion to the retention portion 110. In one example, with regard to the outflow of the substance to the retention portion 110, the fluid is evacuated by sending air into the inside of the spectral filter 20 using an air pump. In addition, the fluid may also be evaporated when the imaging device 100 includes a built-in heating mechanism. Thereafter, the plurality of photoelectric conversion elements 11 receive the light that has transmitted through the wavelength band corresponding to the refractive index of the substance after replacement among the lights incident on the spectral filter 20. For example, in step S104, the spectral filter 20 stores the gas. It is noted that the flow may also return to step S100 again after the execution in step S104.

### [Embodiment 8]

FIG. 14A illustrates an example of a configuration of an optical element 150 according to Embodiment 8. In addition, FIG. 14B and FIG. 14C illustrate examples of a cross sectional view of the optical element 150 according to Embodiment 8. The optical element 150 in this example includes a glass substrate 16, an optical filter 17, and the glass substrate 30. The glass substrate 16 and the glass substrate 30 are provided while sandwiching the optical filter 17. The optical element 150 according to Embodiment 8 may be constituted as part of the imaging device 100 by being disposed in contact with the photoelectric conversion element 11 similarly as in Embodiments 1 to 7 or disposed apart from the photoelectric conversion element 11. In addition, the optical element 150 may be constituted as a stand-alone optical member.

The optical filter 17 includes any optical member. For example, the optical filter 17 includes wire grids 95 as the optical member. In addition, the optical filter 17 stores a substance having a predetermined refractive index. The optical filter 17 in this example stores any one of the substance 24 and the substance 25 that have different refractive indices.

The wire grids 95 perform polarization of light incident on the optical filter 17. The wire grids 95 in this example extend in a direction from the inflow portion 91 to the outflow portion 92 (that is, the flow path direction). In addition, the wire grids 95 are arranged at a predetermined interval in a direction perpendicular to the flow path direction. The wire grids 95 are formed by photolithography and dry etching. A flow path and an outer wall of the optical filter 17 may be formed by the nanoimprint method or the 3D printer similarly as in the fabrication method according to Embodiment 7.

The wire grids 95 in this example have a height H1, a width W1, and a pitch W2. Herein, when the refractive index of the substance is set as n, and the wavelength of the incident light is set as λ, the pitch W2 between the wire grids 95 preferably satisfies the following expression. λ/2 > W2 > λ/2n A structure and an array of the wire grids 95 may be appropriately changed in accordance with a polarization condition of the incident light.

Herein, the optical filter 17 switches polarization and non-polarization by replacing the substance to be stored. For example, the optical filter 17 includes a polarization function by storing air therein. On the other hand, the optical filter 17 loses the polarization function by storing a fluid such as water therein.

As described above, the optical element 150 in this example switches an optical characteristic of the optical filter 17 including the polarization function. That is, the optical element 150 switches polarization and non-polarization of the optical filter 17 by replacing the substance to be stored in the optical filter 17. The optical element 150 in this example can realize the switching of the optical characteristic of the optical filter 17 using the simple structure.

IG. 15 illustrates an example of a fabrication method for the optical element 150 according to Embodiment 8 . In this example, process flows based on the bonding method will be described. It is noted however that the fabrication method for the optical element 150 is not limited to this example.

The glass substrate 16 is prepared, and the resin 55 for nanoimprint is applied onto the glass substrate 16. Side walls (the resin 55) of the optical filter 17 are formed by nanoimprint using the mold 50. Next, the resin 55 is cured by ultraviolet (UV) irradiation. Application of resist 85 for lift-off is performed, and the resist 85 is exposed and developed. The application of the resist 85 is performed so as to cover the side walls, which are formed of the resin 55, of the optical filter 17.

Next, the metallic film 56 is formed on the entire surface. Furthermore, resist 86 is applied onto the metallic film 56, and the resist 86 is exposed and developed. The resist 86 has a pattern in accordance with the wire grids 95. When dry etching is performed over the resist 86, the wire grids 95 are formed of the metallic films 56. Thereafter, the resist 85 and the resist 86 are lifted off. Then, the glass substrate 30 is bonded onto the side walls of the optical filter 17 made of the resin 55 to be joined to each other.

### [Embodiment 9]

FIG. 16A illustrates an example of the configuration of the optical element 150 according to Embodiment 9. FIG. 16B and FIG. 16C illustrate examples of the cross sectional view of the optical element 150 according to Embodiment 9. In the optical element 150 in this example, the optical filter 17 includes any of the substance 24, any of the substance 25, and the optical member. The optical element 150 in this example includes gratings 96 as the optical member. The optical element 150 in this example differs from the optical element 150 according to Embodiment 8 in that the gratings 96 are included instead of the wire grids 95. In this example, a difference from Embodiment 8 will be particularly described. The optical element 150 according to Embodiment 9 may also be constituted as part of the imaging device 100 by being disposed in contact with the photoelectric conversion element 11 similarly as in Embodiment 8 or disposed apart from the photoelectric conversion element 11. In addition, the optical element 150 may also be constituted as a stand-alone optical member.

The gratings 96 diffract the light incident on the optical filter 17. The gratings 96 in this example extend in the direction from the inflow portion 91 to the outflow portion 92 (that is, the flow path direction). In addition, the gratings 96 are arranged at a predetermined interval in the direction perpendicular to the flow path direction. The gratings 96 are formed by photolithography and dry etching. The flow path and the outer wall of the optical filter 17 may be formed by the nanoimprint method or the 3D printer similarly as in the fabrication method according to Embodiment 7.

Herein, the optical filter 17 switches diffraction and non-diffraction by replacing the substance to be stored. For example, the optical filter 17 includes a diffraction function by storing air therein. With reference to FIG. 16B, incident light from a side of the glass substrate 16 is diffracted into zeroth-order light, first-order light, and second-order light by the gratings 96. On the other hand, the optical filter 17 loses the diffraction function by storing a fluid therein. With reference to FIG. 16C, the incident light from the side of the glass substrate 16 is not diffracted by the grating 96.

As described above, the optical element 150 in this example switches the optical characteristic of the optical filter 17 including the diffraction function. That is, the optical element 150 switches diffraction and non-diffraction of the optical filter 17 by replacing the substance to be stored in the optical filter 17,. The optical element 150 in this example can realize the switching of the optical characteristic of the optical filter 17 using the simple structure.

### [Embodiment 10]

FIG. 17A illustrates an example of the configuration of the optical element 150 according to Embodiment 10. FIG. 17B illustrates an example of a plan view of the optical element 150 according to Embodiment 10. FIG. 17C and FIG. 17D illustrate examples of the cross sectional view of the optical element 150 according to Embodiment 10. The optical element 150 in this example includes the plurality of flow paths 90, the plurality of inflow portions 91, and the plurality of outflow portions 92. It is noted that, for simplicity, FIG. 17A illustrates only a pair of the inflow portions 91 and the outflow portion 92, but the plurality of inflow portions 91 and the plurality of outflow portions 92 may also be provided.

The flow path 90 includes the four flow paths 90a to 90d. The flow paths 90a to 90d have circular outer shapes in a plan view. For example, the flow paths 90a to 90c have donut-like planar shapes. The flow path 90d has a circular planar shape. The flow paths 90a to 90d are provided from an outer circumference side in a concentric fashion. That is, the flow path 90b is disposed on an inner side of the flow path 90a, the flow path 90c is disposed on an inner side of the flow path 90b, and the flow path 90d is disposed on an inner side of the flow path 90c.

A predetermined substance is stored in the flow paths 90a to 90d. With reference to FIG. 17C, a gas is stored in the flow paths 90a to 90d as the substance 24. Air is stored in all the flow paths 90a to 90d in this example. On the other hand, with reference to FIG. 17D, a fluid is stored in the flow paths 90a to 90d as the substances 25 to 28. The flow paths 90a to 90d in this example respectively store the substances 25 to 28 that have different refractive indices. It is noted however that the flow paths 90a to 90d may store the same substance.

The optical element 150 in this example replaces the substance to be stored with the air and the fluid and also uses a plurality of fluids having different refractive indices. According to this, the optical element 150 switches aperture and light shielding corresponding to optical characteristics of the imaging apparatus. For example, the optical element 150 arbitrarily changes a light shielding region by changing the substances 25 to 28 that flow through the flow paths 90. According to this, an F-number of the imaging apparatus may also be controlled. In addition, the optical element 150 may also function as a shutter by combining a light shielding function with a function for changing the aperture.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### EXPLANATION OF REFERENCES

10 ··· light receiving portion, 11 ··· photoelectric conversion element, 15 ··· oxide film, 16 ··· glass substrate, 17 ··· optical filter, 20 ··· spectral filter, 21 ··· mirror, 22 ··· storage portion, 23 ··· mirror, 24 ··· substance, 25 ··· substance, 26 ··· substance, 27 ··· substance, 28 ··· substance, 30 ··· glass substrate, 31 ··· oxide film, 32 ··· metallic film, 40 ··· multilayer interference film, 41 ··· storage portion, 42 ··· base material, 50 ··· mold, 55 ··· resin, 56 ··· metallic film, 57 ··· resin, 58 ··· metallic film, 59 ··· oxide film, 60 ··· pillar layered portion, 61 ··· storage portion, 62 ··· base material, 63 ··· pillar, 80 ··· lens portion, 85 ··· resist, 86 ··· resist, 90 ··· flow path, 91 ··· inflow portion, 92 ··· outflow portion, 93 ··· hollow portion, 94 ··· connecting portion, 95 ··· wire grid, 96 ··· grating, 100 ··· imaging device, 110 ··· retention portion, 150 ··· optical element, 200 ··· 3D printer, 300 ··· imaging apparatus

## Claims

1. An imaging device comprising:
a light receiving portion including a plurality of photoelectric conversion elements arranged in a two-dimensional manner; and
a spectral filter including a storage portion that stores a substance composed of a fluid or a gas, an inflow portion through which the substance flows into the storage portion, and an outflow portion through which the substance flows out from the storage portion, the spectral filter having a spectral characteristic corresponding to a refractive index of the substance, the spectral filter being each provided for one or more of the photoelectric conversion elements.

2. The imaging device according to Claim 1, wherein,
in a state where a first substance having a first refractive index is stored in the storage portion as the substance, the spectral filter switches a wavelength band in which light transmits from a first wavelength band to a second wavelength band when the first substance flows out from the outflow portion, and also a second substance having a second refractive index flows in from the inflow portion as the substance.

3. The imaging device according to Claim 1 or 2, wherein
the spectral filter includes a multilayer interference film in which a base material having a third refractive index and the storage portion are alternately laminated in multiple layers, and wherein
the storage portion stores the substance having a refractive index different from the third refractive index.

4. The imaging device according to Claim 3, wherein
the storage portion includes a plurality of pillar structures having a refractive index different from the third refractive index.

5. The imaging device according to Claim 4, wherein
the refractive index of the pillar structure is higher than the third refractive index.

6. The imaging device according to Claim 4 or 5, wherein
the spectral filter includes the pillar structure having a different cross sectional area in an array direction of the photoelectric conversion elements for each of the storage portions corresponding to the one or more of photoelectric conversion elements.

7. The imaging device according to Claim 1 or 2, wherein
the spectral filter is a filter based on a Fabry-Perot interference film method, the filter including a pair of mutually facing reflective surfaces while sandwiching the storage portion.

8. The imaging device according to Claim 7, wherein
the spectral filter includes the storage portion sandwiched by the pair of reflective surfaces for each block constituted by the plurality of photoelectric conversion elements, and wherein,
in the storage portion, an interval between the pair of reflective surfaces each varies for one or more of the photoelectric conversion elements in one of the blocks.

9. The imaging device according to Claim 8, wherein
the spectral filter includes an inlet that allows inflow of the substance from the inflow portion into the storage portion and an outlet that allows outflow of the substance from the storage portion to the outflow portion, the inlet and the outlet facing each other with regard to an array direction of the photoelectric conversion elements, and wherein,
in the storage portion, the interval is gradually widened from the inlet towards the outlet.

10. An imaging apparatus comprising:
the imaging device according to any one of Claims 1 to 9; and
a retention portion that is connected to the inflow portion and the outflow portion and retains the substance flowing out from the storage portion,
the retention portion causing the retained substance to flow into the inflow portion and causing the substance to be stored in the storage portion again.

11. An optical filter comprising:
a storage portion that stores a substance composed of a fluid or a gas;
an inflow portion through which the substance flows into the storage portion; and
an outflow portion through which the substance flows out from the storage portion, the optical filter having an optical characteristic corresponding to a refractive index of the substance.

12. An imaging method for performing imaging based on lights received by a plurality of photoelectric conversion elements arranged in a two-dimensional manner, the imaging method comprising:
causing a substance composed of a fluid or a gas to flow from an inflow portion into a storage portion of a spectral filter, the spectral filter being provided to correspond to one or more of the plurality of photoelectric conversion elements;
causing the plurality of photoelectric conversion elements to receive light that has transmitted due to a spectral characteristic corresponding to a refractive index of the substance among lights incident on the spectral filter; and
causing the substance to flow out from the storage portion to an outflow portion.
